(19)

Europäisches Patentamt
European Patent Office
Office européen des brevets

(11) **EP 2 437 297 A1**

(12) **EUROPEAN PATENT APPLICATION**

(43) Date of publication:
**04.04.2012 Bulletin 2012/14**

(51) Int Cl.:
***H01L 27/146*** (2006.01)          ***H04N 5/335*** (2011.01)
***G01T 1/17*** (2006.01)

(21) Application number: **10186002.1**

(22) Date of filing: **01.10.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Paul Scherrer Institut
5232 Villigen (CH)**

(72) Inventors:
• **Johnson, Ian
5116, Schinznach Bad (CH)**

• **Schmid, Elmar
4313, Möhlin (CH)**
• **Suter, Dominic
5303, Würenlingen (CH)**
• **Theidel, Gerd
8001, Zürich (CH)**

(74) Representative: **Fischer, Michael
Siemens AG
Postfach 22 16 34
80506 München (DE)**

(54) **A method for correction of high rate inefficiencies of a single photon counting detector system and single photon counting detector system**

(57)     It is an objective of the present invention to provide a method for correction of high rate inefficiencies of a single photon counting detector system and single photon counting detector system having this property in order be more precise in terms of photon counting.

This objective is achieved according to the present invention by a method and a single photon counting pixel detector (chip or multi chip), comprising:
a) a layer of photosensitive material;
b) an N x M array of photo-detector diodes arranged in said layer of photosensitive material; each of said photo-detector diodes having a diode output interface;
c) a N x M array of readout unit cells, one readout unit cell for each photo-detector diode;

d) said readout unit cell comprising an input interface connected to said diode output interface, a high-gain charge to voltage amplifying means and a pixel counter being connected to an output of the high-gain voltage amplifying means,
e) a calculation means for integrating the total number of incident photons over a predetermined total exposure time, wherein the total exposure time is split into sub-exposure intervals, wherein distinct rate corrections are applied to the sub-counts of the sub-exposure intervals and then the number of incident photons is calculated by summing the sub-counts which are individually corrected.

EP 2 437 297 A1

## Description

The present invention relates to a method for correcting inefficiencies at high rates of single photon counting detector systems and single photon counting detector systems having a high rate inefficiency correction mechanism.

## Current state of the art (for single photon counting)

Hybrid pixel detectors consist of a X-ray sensitive layer (silicon sensor) and a readout chip, both divided into corresponding pixels. Each pixel in the sensor is directly connected (bump bonding or flip chip bonding) to the corresponding pixel in the readout chip. The pixel size is therefore limited by the pixel size in the readout chip and the number of electronic components per pixel in the readout chip is very limited and additional electronics to extend the rate capabilities of the detector system are therefore hardly possible to implement. A generic pixel detector of this type is generally disclosed in the European Patent Application 1 581 971 A1.

The readout chip contains an array of n x m independently working channels (pixels). Each channel has a charge sensitive preamplifier with tunable gain, a signal shaper with tunable shaping time, a comparator and a counter with simple pixel control and readout logic. A photon impinging a sensor pixel generates electron-hole pairs. These electron-hole pairs are separated by an electric field generating a charge pulse. This charge signal from the sensor is amplified and filtered by the low noise preamplifier and shaper in the corresponding pixel cell (in the readout chip). The shaped signal is fed to a comparator with a global reference voltage and an on-pixel trim DAC. An incoming signal exceeding this threshold will toggle the comparator state. If the chip is in *Expose* mode (counting the photons), the comparator pulse increments the digital counter by one. During the *Readout* phase the pixel counter states are transferred to the chip periphery, where they are readout via dedicated readout logic.

The known state of the art according to the EP 1 581 971 A1 has several limitations for single photon counting:

i) A general problem of readout pixel chips is related to the pixel size. Known pixel detector have a pixel size in the range of about 172 $\mu m^2$. A smaller pixel size can increase the image resolution, but limits also the number of transistors, and hence the functionality, that can be put on the pixel itself. This is specifically the case for radiation hard designs where the transistors are larger as compared to standard transistors.

ii) For fast frame rates the readout time (dead time) is very significant and limits the frame rate. Many measurements are currently limited by the frame rate. The pixel detector known in the prior art having 256 x 256 pixels at a data depth of 12 bit requires at a read-out rate of 200 MHz about 4 to 6 ms for its readout.

iii) For pump and probe measurements a sample is excited (pumped) and then after a selectable time the counting is enabled for a short period (probe). This is then repeated as often as required to gain statistics, accumulating the images. Where the conditions are not constant it is necessary to make (at least) 2 simultaneous measurements (usually pumped and un-pumped). This is currently not possible since the counts can only be accumulated in one internal counter.

iv) Further, this detector system basically suffers from inefficiencies at high rates of incoming photons. In order to cope with this problem a rate correction mechanism is provided to correct at high rates (hundreds of kHz) the efficiencies. These efficiencies at high incoming rates are predominantly caused by the overlap of analogue signals of the pre-amplifier from temporally adjacent photons that are counted as a single event instead of independent events. The size of the overlap window is a function of the temporal shaping and the signal discriminator threshold of the detector. Thus, the probability for overlapping events, moreover the probability to miss events, increases as the probability of adjacent events arriving with shorter temporal spacing increases, i.e. at higher photon fluxes.

Current methods correct for this inefficiency by applying a flux dependent correction factor to the average flux over the complete exposure interval. Typically, corrections are based on the following analytic model,

$$N_{obs} = N_0 \ \exp(-N_0 * \tau)$$

where $N_{obs}$ stands for the detected rate, No for the true incident photon rate and $\tau$ is the dead-time, ie. The minimum required time between two temporally adjacent photons such that both are counted.

Usually an off-line rate correction in software is applied using the equation above by creating a look-up table which maps the recorded counts ($N_{obs}(t)$) to the corresponding incident counts ($N_0$ (t)). This table has to be recreated for a specific dead-time and a specific exposure time, when either of them is changed.

The current method comprises a number of disadvantages:

a) the rate correction is averaged over the complete exposure interval, and therefore, is accurate only when the intensity of the events on the detector is constant throughout the complete acquisition time. Thus, current methods do not treat variations in the intensity caused by changes in the sample or temporal instabilities in the x-ray sources during the acquisition time. Unfortunately, changes in the sample condition, today, is specifically a problem in protein crystallography where a continuous rotation of a single crystal can cause the intensity of Bragg peak to vary from 0 to 100% and back to 0 during just one single exposure interval. Diffraction experiments with sample under non-ambient conditions (like temperature scans, application of external stress etc.) also have the potential for dramatic changes in intensity during an exposure interval.

b) the rate correction factors that correspond to the variable complete exposure time are a function of the complete exposure time and thus must be recalculated based on the actual exposure time of each individual acquisition.

It is therefore an objective of the present invention to provide a single photon-counting pixel detector (chip or multi chip assembly) and a method for correction of high rate inefficiencies of a single photon counting detector system and single photon counting detector system having this property in order to be more precise in terms of photon counting.

This objective is achieved according to the present invention by a single photon counting pixel detector chip or multi chip assembly, comprising:

a) a layer of photosensitive material;
b) an N x M array of photo-detector diodes arranged in said layer of photosensitive material; each of said photo-detector diodes having a diode output interface;
c) a N x M array of readout unit cells, one readout unit cell for each photo-detector diode;
d) said readout unit cell comprising an input interface connected to said diode output interface, a high-gain charge to voltage amplifying means and a pixel counter being connected to an output of the high-gain voltage amplifying means,
e) a calculation means for integrating the total number of incident photons over a predetermined total exposure time, wherein the total exposure time is split into sub-exposure intervals, wherein distinct rate corrections are applied to the sub-counts of the sub-exposure intervals and then the number of incident photons is calculated by summing the subcounts which are individually corrected.

With respect to the method this objective is achieved according to the present invention by a method for correcting a total number of photons being counted over a predetermined total exposure time by a single photon counting pixel detector chip or multi chip assembly, comprising the steps of:

a) providing the single photon counting pixel detector chip comprising:

i) a layer of photosensitive material;
ii) an N x M array of photo-detector diodes arranged in said layer of photosensitive material; each of said photo-detector diodes having a diode output interface;
iii) a N x M array of readout unit cells, one readout unit cell for each photo-detector diode; and
iv) said readout unit cell comprising an input interface connected to said diode output interface, a high-gain charge to voltage amplifying means and a pixel counter being connected to an output of the high-gain voltage amplifying means,

b) integrating the total number of incident photons over the predetermined total exposure time, wherein the total exposure time is split into sub-exposure intervals that are summed together,
c) applying distinct rate corrections to the counts of the respective sub-exposure intervals; and
d) calculating the number of incident photons by summing the corrected counts of all sub-exposure intervals over the total exposure time.

This detector chip or multi chip assembly and method allows the correction of incident photons coming in at high frequencies. By the definition of sub-exposures intervals, two main advantages can be achieved: 1) The rate corrections on the very short sub-exposures correspond to more instantaneous, less time averaged rate corrections, therefore, leading to a more precise overall correction. 2) equal length sub-exposure intervals lead to a single discrete list of rate correction factors.
In a preferred embodiment of the present invention, the total exposure time may be divided into equal acquisition time sub-exposure intervals. The length of the sub-exposure interval (few ms) is chosen to balance a shorter, more accurate (less averaged) sub-exposure time; with statistics in the sub-events and the inefficiency arising from unavoidable readout related pauses between sub-events.
In a further preferred embodiment of the present invention, the length of the sub-exposure interval is fixed and independent of the incoming flux, thus the rate correction factors are only a function of preamp shaping (dead time i). It is, therefore, possible to provide a single discrete list of correction factors that can be applied. I.e., the rate correction factors are defined for a fixed sub exposure time $t_{sub}$ and must in this case not be recalculated in order to correspond to the variable total exposure time $t_{total}=n*t_{sub}$ since $t_{sub}$ can be held constant and only n changes to change $t_{otal}$.
Further preferred embodiments of the present invention can be taken from the remaining depending claims.

Preferred embodiments of the present invention are hereinafter discussed in more detail with reference to the following drawings which depicts in:

Figure 1     a schematic view of the design of a photo-detector diode;

Figure 2     a schematic view of a part of a detector module comprising an array of photo-detector diodes as one of them is shown in Figure 1;

Figure 3     a schematic view of a readout unit cell comprising an input interface connected to said diode output interface, a charge sensitive preamp/shaper, discriminator and counter.

Figure 4     a plot of the incident intensity on a pixel (dashed curve), the uncorrected measured prior art distribution (courser-binned distribution) and the uncorrected measured sub-exposures distribution of the present invention (finer-binned distribution);

Figure 5     a plot of the percent error in the rate correction over an exposure time according to the prior art (dashed distribution) and with rate correction for each individual sub-exposure interval according to the present invention (solid line distribution);

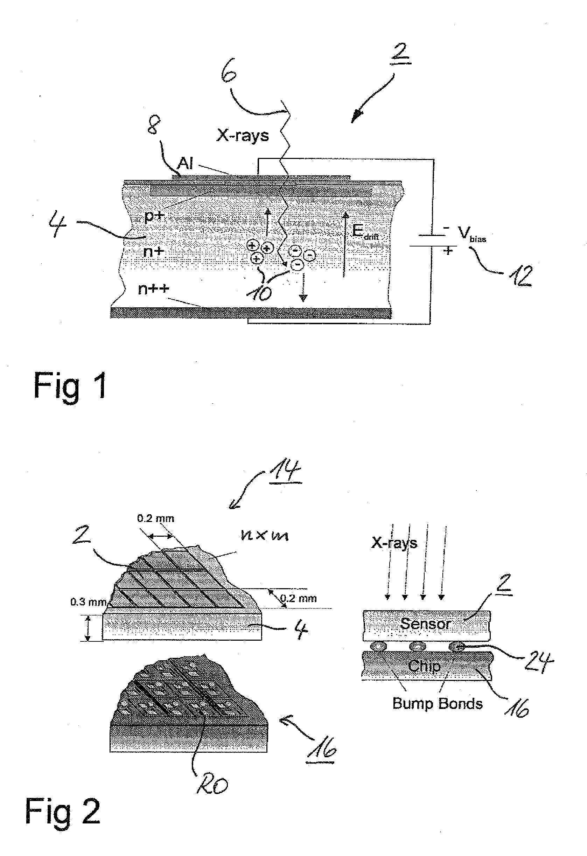

Figures 1 illustrates schematically the architecture of a photo-detector diode 2 having a doped semiconductor $p^+$, $n^-$, $n^{++}$ trespassing section 4. The most commonly used material is a silicon crystal but also germanium, gallium arsenide or cadmium telluride are used.

An incident photon 6 having an energy in the range of 100 eV to several KeV before entering the doped semiconductor $p^+$, $n^-$, $n^{++}$ trespassing section 4 passes through a possible cover layer (e.g. aluminum) 8 and causes according to its energy and to the energy needed to create an electron hole pair a respective number of electron hole pairs 10 after x-ray absorption. In the drawings, this number of electron hole pairs is exemplarily shown by three electron-hole pairs 10 being divided by the electrical field generated by a source of bias potential 12.

Figure 2 shows a schematic view of a two-dimensional pixel detector 14 having a number of photo-detector diodes 2 arranged in an array of n rows and m columns. The photo detector diodes 2 have a length 1 and a width w of about 200 $\mu$m (or less) and a height of about 300 $\mu$m. Below the plane of these photo-detector diodes 2 a readout chip 16 having a corresponding number of readout unit cells RO is arranged for collecting the charge from the electron hole pairs 10 generated in the respective photo-detector diodes 2. The electrical conjunction between a diode output interface of the pho-

to-detector diodes 2 and an input interface IN of the readout unit cell RO is achieved by bump bonding using for example indium bumps 24.

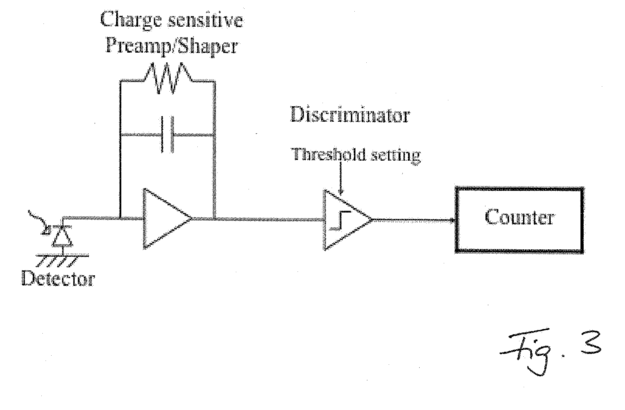

Figure 3 shows a schematic view of a readout cell. In which the charge signal is amplified and filtered by the low noise preamplifier and shaper in the corresponding pixel cell (in the readout chip). The shaped signal is fed to a comparator with a global reference voltage and an on-pixel trim DAC. An incoming signal exceeding this threshold will toggle the comparator state. If the chip is in *Expose* mode (counting the photons), the comparator pulse increments the digital counter by one.

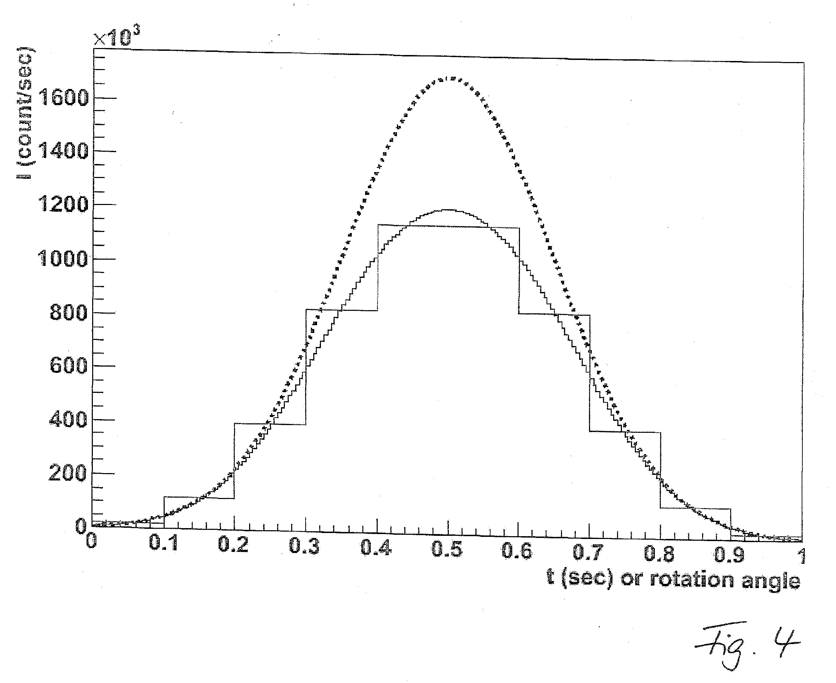

Figure 4 shows a Gaussian like fluctuation example of the incident intensity on a pixel as a function of time or rotation angle. The upper dashed curves represents the incident intensity impinging on the pixel, while the two lower distributions represent the uncorrected measured intensity distribution in which events that temporally overlap are lost (200 ns dead time assumed). The lower courser-binned, distribution represents a prior art measurements, where measurements are taken every 100 ms as "desired" by the experiment. The finer binned distribution represents the uncorrected sub-exposures of the current invention, for which the sub-exposure bins (e.g. 5ms) are first individually rate corrected then combined into the courser "experimentally desired" 100 ms bins.

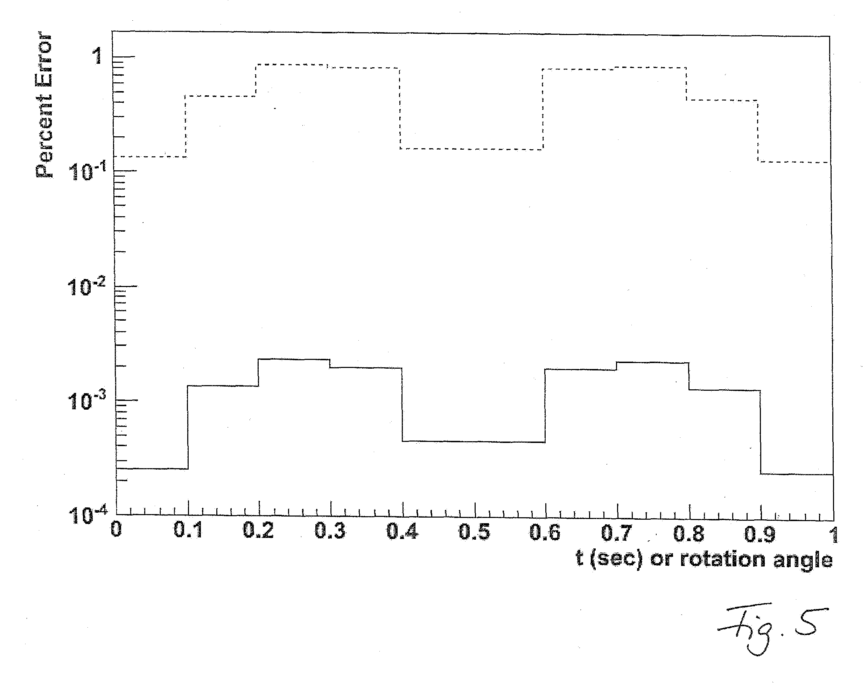

Figure 5 shows the percent error of the measured intensity distribution after rate corrections are applied: a) the dashed upper distribution is the percent error in the prior art's rate correction where the corrections are applied on the "experimentally desired" 100 ms bins. b) the lower solid distribution is the percent error of the current invention's rate correction, in which the 5 ms sub-exposure were first individually rate corrected then summed into the "experimentally desired" 100 ms bins.

Further, this sub-exposure rate correction can preferably be implemented in hardware (e.g. on an FPGA in the readout system). This avoids the big overhead in data transfer and data processing that would be necessary if all sub-exposures counts would have to be transferred, stored and post processed. This also makes much shorter sub-exposure intervals possible since the frame rate for the sub exposures is not limited by the data transfer or storage rate.

**Claims**

1.   A single photon counting detector system having a high rate inefficiency correction mechanism, comprising:

     a) a layer of photosensitive material (4);
     b) an N x M array of photo-detector diodes (2) arranged in said layer of photosensitive material (4); each of said photo-detector diodes (2) having a diode output interface (24);

c) a N x M array (16) of readout unit cells (RO), one readout unit cell (RO) for each photo-detector diode (2);

d) said readout unit cell (RO) comprising an input interface (IN) connected to said diode output interface (24), a high-gain charge to voltage amplifying means (PA) and a pixel counter (Cs) being connected to an output (OUT) of the high-gain voltage amplifying means (PA),

e) a calculation means (DPM) for integrating the total number of incident photons over a predetermined total exposure time ($t_E$), wherein the total exposure time ($t_E$) is split into sub-exposure intervals ($\Delta t_E$), wherein distinct rate corrections (RC) are applied to the sub-counts of the sub-exposure intervals and then the number of incident photons is calculated by summing the sub-counts which are individually corrected.

2. The single photon counting pixel detector chip according to claim 1 wherein the total exposure time is divided into equally lasting sub-exposure intervals.

3. The single photon counting pixel detector chip according to claim 1 wherein the length of the sub-exposure interval is chosen to balance a shorter, more accurate (less averaged) sub-exposure time; with statistics in the sub-events and the inefficiency arising from unavoidable readout related pauses between sub-events.

4. The single photon counting pixel detector chip according to any of the preceding claims wherein the sub-exposure length is fixed and rate correction factors are only a function of temporal dead time between adjacent photons, which is a function of the preamp settings.

5. The single photon counting pixel detector chip according to any of the preceding claims wherein a single list of rate correction factors can be applied, removing the necessity to recalculated the factors for the variable total exposure time.

6. A method for correcting high rate inefficiencies of a single photon counting detector system wherein a total number of photons being counted over a predetermined total exposure time by a single photon counting detector system, comprising the steps of:

    a) providing the single photon counting pixel detector chip comprising:

        i) a layer of photosensitive material;
        ii) an N x M array of photo-detector diodes arranged in said layer of photosensitive material; each of said photo-detector diodes having a diode output interface;

        iii) a N x M array of readout unit cells, one readout unit cell for each photo-detector diode; and
        iv) said readout unit cell comprising an input interface connected to said diode output interface, a high-gain charge to voltage amplifying means and a pixel counter being connected to an output of the high-gain voltage amplifying means,

    b) integrating the total number of incident photons over the predetermined total exposure time, wherein the total exposure time is split into sub-exposure intervals,

    c) applying distinct rate corrections to the sub-counts of the respective sub-exposure intervals; and

    d) calculating the number of incident photons by summing the sub-counts of all sub-exposure intervals over the total exposure time.

7. The method according to claim 6 wherein the total exposure time is divided into equally lasting sub-exposure intervals.

8. The method according to claim 6 wherein the length of the sub-exposure interval is independent of the level of incoming photons.

9. The method according to any of the preceding claims 6 to 8 wherein the rate correction is chosen depending on the preamp settings and the length of the sub-exposure interval.

10. The method according to any of the preceding claims 5 to 9 wherein a single list of rate correction factors can be applied in the hardware of the front-end electronics before data is transferred to a data handling unit.

11. The method according to any of the preceding claims 5 to 10 wherein the number of incident photons, i.e. the sum of the corrected sub-exposures, can be applied in the hardware of the front-end electronics before data transfer to the pc avoiding unnecessarily sub-exposure data transfer.

12. The method according to any of the preceding claims 5 to 11 wherein a statistical balance of the sub-count of the sub-exposure interval prior to the current sub-exposure interval is the argument in order to determine the length of the current sub-exposure interval and the rate correction applied to the current sub-exposure interval.

**Fig 1**

**Fig 2**

Fig. 3

Fig. 4

EP 2 437 297 A1

Fig. 5

EP 2 437 297 A1

Europäisches
Patentamt

European
Patent Office

Office européen
des brevets

**EUROPEAN SEARCH REPORT**

Application Number

EP 10 18 6002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KRAFT, BERGAMASCHI,DINAPOLI,HEINRICH ET AL: "Performance of single photon counting PILATUS detector modules", JOURNAL OF SYNCHRON RADIATION, 22 December 2008 (2008-12-22), pages 368-375, XP002632471, ISSN: 0909-0495 * abstract * * paragraph [03.4]; figure 2 * ----- | 1,6 | INV. H01L27/146 H04N5/335 G01T1/17 |
| A | WO 2009/043003 A1 (EV PRODUCTS INC [US]; RUNDLE DAVID S [US]) 2 April 2009 (2009-04-02) * paragraph [0012]; figures 4,6 * ----- | 1,6 | |
| A | JP 2008 191044 A (NAT INST OF ADV IND & TECHNOL) 21 August 2008 (2008-08-21) * abstract * * paragraphs [0014], [0019] * ----- | 1,6 | |
| | | | TECHNICAL FIELDS SEARCHED (IPC) H01L H04N G01T |

The present search report has been drawn up for all claims

| Place of search | Date of completion of the search | Examiner |
|---|---|---|
| The Hague | 12 April 2011 | Zakharian, Andre |

**ANNEX TO THE EUROPEAN SEARCH REPORT
ON EUROPEAN PATENT APPLICATION NO.**                EP 10 18 6002

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2011

| Patent document cited in search report | Publication date | Patent family member(s) | Publication date |
|---|---|---|---|
| WO 2009043003 A1 | 02-04-2009 | NONE | |
| JP 2008191044 A | 21-08-2008 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1581971 A1